# EUROPEAN PATENT APPLICATION

(11) **EP 3 495 535 A1**
(43) Date of publication of application: **12.06.2019**
(21) Application number: 18209249.4
(22) Date of filing: 29.11.2018
(51) Int. Cl.: C23C 14/56, H01L 21/67

(54) **COATING APPARATUS**

(30) Priority: 06.12.2017 CN 201721687021 U
(71) Applicant: Beijing Apollo Ding Rong Solar Technology Co., Ltd., Beijing 100176 (CN)
(72) Inventor: Shi, Shuanlin, Beijing, Beijing 100176 (CN)
(74) Representative: Cohausz & Florack

(57) **Abstract**

The present disclosure provides a coating apparatus for coating on a substrate surface including a plurality of separation chambers (3) and a plurality of target material coating chambers (1), wherein at least one separation chamber (3) is arranged between the two adjacent target material coating chambers (1); a plurality of diaphragms (5), which divide the internal of the coating apparatus into the plurality of separation chambers (3) and a plurality of target material coating chambers (1), wherein each of the diaphragms (5) is provided with a slit (7), so that the substrate moves between the target material coating chamber (1) and the separation chamber (3) through the slit (7); and a blowing device (8), which is arranged in one separation chamber (3) and blows gas through the slit (7) to the target material coating chamber (1) adjacent to the slit (7).

## Description

### CROSS REFERENCE

This application is based upon and claims the priority of the Chinese Patent Application No. 201721687021.0, filed on Dec. 6, 2017 in the Chinese National Intellectual Property Office, entitled "PLATES COATING APPARATUS WITH THE FUNCTION OF PREVENTING GAS FLOWING", the entire contents thereof are incorporated herein by reference.

### TECHNICAL FIELD

The present disclosure relates to the field of transportation vehicles, and in particular to a solar transportation vehicle. The present disclosure relates to a coating apparatus, and in particular to a coating apparatus with the function of preventing gas flowing.

### BACKGROUND

In the coating apparatus, according to the different preparation process requirements of the substrate film layers, the substrate needs to pass through several coating chambers in turn, and the corresponding film layer to meet the different demand is produced in turn. In addition, according to the different preparation requirements of the different film layers, the sputtering gas in each target material coating chamber is adjusted accordingly. Sometimes, in addition to the main sputtering gas, different auxiliary sputtering gases can be added as needed. For example, auxiliary sputtering gases such as O₂, H₂, N₂ may be added to the coating process of different chambers. Therefore, the target materials and the sputtering gases of each target material coating chamber are different. In order to prevent the sputtering gas from the adjacent target material coating chamber escaping through the substrate transmission channel and affect the coating quality, the gases in the different target material coating chamber should be separated to ensure the coating quality.

### SUMMARY

In order to solve at least some of the technical problems existing in the related techniques, the present disclosure provides a coating apparatus which can effectively isolate the sputtering gases in the different coating chambers of the coating apparatus, prevent the sputtering gases flowing between the adjacent coating chambers, and ensure the coating quality. The coating apparatus has the advantages of simple structure and low manufacturing cost.

According to one aspect of the present disclosure, a coating apparatus is provided for coating the substrate surface.

The coating apparatus includes a plurality of separation chambers and a plurality of target material coating chambers, wherein at least one separation chamber is arranged between the two adjacent target material coating chambers;

a plurality of diaphragms, which divide the internal of the coating apparatus into the plurality of separation chambers and a plurality of target material coating chambers, wherein each of the diaphragms is provided with a slit, so that the substrate moves between the target material coating chamber and the separation chamber through the slit;

a blowing device, which is arranged in one separation chamber and blows gas through the slit to the target material coating chamber adjacent to the slit.

In some embodiments, the adjacent two target material coating chambers of the coating apparatus includes first target material coating chamber and a second target material coating chamber; the diaphragms include a first diaphragm and a second diaphragm; the slits include a first slit and a second slit, the blowing devices include a first blowing device and a second blowing device; wherein

the first diaphragm is arranged between the first target material coating chamber and the adjacent separation chamber, the first slit is arranged on the first diaphragm;

the second diaphragm is arranged between the second target material coating chamber and the adjacent separation chamber, and the second slit is arranged on the second separation;

the first blowing device is used for blowing gas to the first target material coating chamber through the first slit, and the second blowing device is used for blowing gas to the second target material coating chamber through the second slit.

In some embodiments, the coating apparatus further includes:
a first pump chamber, which is arranged in the first target material coating chamber and is near the first diaphragm, and
a second pump chamber, which is arranged in the second target material coating chamber is near the second diaphragm,
wherein the first pump chamber and the second pump chamber are provided with a molecular pump respectively, the molecular pump in the first pump chamber is used to absorb gas blown back from the first slit by the first blowing device, the molecular pump in the second pump chamber is used to absorb gas blown back from the second slit by the second blowing device.

In some embodiments, a molecular pump is arranged in the separation chamber for absorbing gas in the separation chamber.

In some embodiments, the first blowing device is arranged on one side of the first diaphragm facing to the separation chamber, and the second blowing device is arranged on the other side of the second diaphragm facing to the separation chamber.

In some embodiments, each of the first blowing device and the second blowing device includes:
an end plate, the end plate is fixed at the slit;
a pipe is fixed on the end plate, and the pipe extends along the direction of the length of the corresponding slit;
one or more nozzles are arranged in the pipe;
a pipeline is used to connect the pipe and the gas source; and
a flow control valve is arranged on the pipe;
wherein the slit corresponding to the first blowing device is the first slit, and the slit corresponding to the second blowing device is the second slit.

In some embodiments, the pipe is arranged around the edge of the slit.

In some embodiments, the slit is circular, and the pipes includes:
an inner ring pipe, which is located inside the circular slit, and
an outer ring pipe, which is located outside the circular slit.

In some embodiments, the nozzles of the first blowing device blow towards the first slit, the center axis of the nozzles and the plate surface of the first diaphragm shows a first inclination angle α, the first inclination angle α is 30-60 degrees, and an outlet of the nozzles of the first blowing device is oriented towards the molecular pump in the first pump chamber adjacent to the nozzle.

In some embodiments, the nozzles of the second blowing device blow towards the second slit, the center axis of the nozzles and the plate surface of the second diaphragm shows a second inclination angle α, the second inclination angle α is 30-60 degrees, and an outlet of the nozzles of the second blowing device is oriented towards the molecular pump in the second pump chamber adjacent to the nozzle.

In some embodiments, the nozzles are arranged evenly along the extension direction of the pipe.

In some embodiments, the end plate is located at least one end of the slit, and the end plate is elastic along the length direction of the slit so that the end plate covers an area of the slit adjustable.

In some embodiments, the pipe is detachable with the end plate.

In some embodiments, an inner surface of the first slit and an inner surface of the second slit are rough surfaces, and the roughness of each inner surfaces is Ra > 6.3.

In some embodiments, the number of the molecular pumps in the first pump chamber is equal to the number of the molecular pumps in the second pump chamber, and a sum of the number of the molecular pumps in the first pump chamber and the number of the molecular pumps in the second pump chamber is a first value, a sum of the number of the molecular pumps in the separation chamber is a second value, and the first value is equal to the second value.

In the embodiments of the present disclosure, an isolation chamber is arranged between the adjacent target material coating chambers of the coating apparatus, and a blowing device is arranged in the separation chamber, through which a pressure barrier can be formed at the slit. On the other hand, the gas from the target material coating chamber can be blown back into the target material coating chamber, which can effectively isolate the various target material coating chambers of the coating apparatus, reduce gases flowing between the target material coating chambers, and improve the quality of coating.

### BRIEF DESCRIPTION OF THE DRAWINGS

In order to more clearly illustrate the technical solutions of the embodiments of the present disclosure, the drawings used in the embodiments and the related art description will be briefly described below. Apparently, the drawings in the following description are only some implementations of the present disclosure. For those skilled in the art, other equivalent embodiments and modifications may be obtained in accordance with the exemplary embodiments disclosed herein without departing from the scope of the present disclosure.
Fig. 1 is a top view of a coating apparatus according to one embodiment of the present disclosure.
Fig. 2 is a top view of a coating apparatus according to another embodiment of the present disclosure.
Fig. 3 is an axonometric view showing the configuration and arrangement position of a first blowing device according to one embodiment of the present disclosure.
Fig. 4 is an axonometric view showing the configuration and arrangement position of a second blowing device according to one embodiment of the present disclosure.
Fig. 5 is a schematic view showing an angle between nozzles and the plate surface of the first diaphragm according to one embodiment of the present disclosure.
Fig. 6 is a schematic view showing a configuration of a gas pipe and a slit according to one embodiment of the present disclosure.

### DETAILED DESCRIPTION

The embodiments of the present disclosure are described in detail below with reference to the drawings in which identical or similar elements or elements having the same or similar functions are represented by the same or similar labels. It should be understood that the following embodiments described by reference to the drawings are exemplary and can only be used to explain this disclosure and cannot be interpreted as limiting the disclosure.

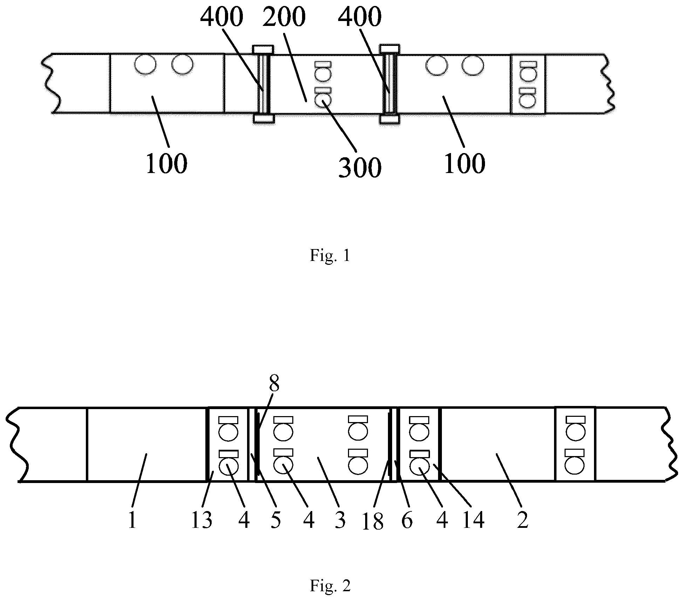

Fig. 1 is a top view of a coating apparatus according to one embodiment of the present disclosure. As shown in Fig. 1, in a coating apparatus provided by one embodiment of the present disclosure, according to the sputtering process requirements of the different target materials, the coating apparatus is provided with two interconnected target material coating chambers 100, and an separation chamber 200 is arranged between the two interconnected target material coating chambers 100. A molecular pump 300 is arranged in the separation chamber 200, which is used to absorb the gas that flows to the separation chamber 200 from one of the target material coating chamber 100 to the separation chamber 200. A flip valve 400 is installed on each side of the separation chamber 200 to replace a door sheet between the separation chamber 200 and the target material coating chamber 100, so as to realize the gas isolation of the different target material coating chambers 100.

Fig. 2 is a top view of a coating apparatus according to another embodiment of the present disclosure. As shown in Fig. 2, the present disclosure provides a coating apparatus according to another embodiment of the present disclosure. The coating apparatus is used to reduce gas flowing between the adjacent target material coating champers 1. The coating apparatus includes a plurality of separation chamber 3 and a plurality of target material coating champers 1. In one optional embodiment, at least one separation chamber 3 is arranged between two adjacent target material coating champers 1, such as one or two separation chamber 3, to meet the different gas isolation requirements between the adjacent target material coating champers 1. The coating apparatus also includes a plurality of diaphragms 5, by which a plurality of separation champers 3 and a plurality of target material coating champers1 are divided. Each of the diaphragms 5 is provided with a slit. The substrate moves through the slit between the target material coating chamber 1 and the separation chamber 3. The coating apparatus also includes a blowing device arranged in the separation chamber 3. The blowing device blows through the slit to the target material coating chamber adjacent to the slit. It should be noted that the term "the target material coating chamber adjacent to the slit" here means the target material coating chamber directly adjacent to the diaphragm on which the slit is located.

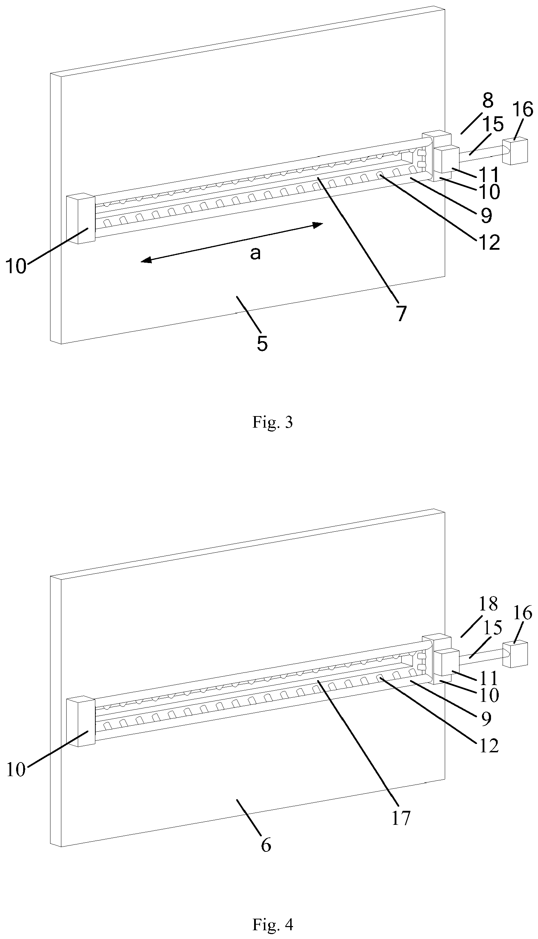

In an exemplary embodiment of the present disclosure, as shown in Fig. 2, two adjacent target material coating chambers in the coating apparatus include a first target material coating chamber 1 and a second target material coating chamber 2. The diaphragms include a first diaphragm 5 and a second diaphragm 6. The slits include a first slit 7 and a second slit 17. The first diaphragm 5 is arranged between the first target material coating chamber 1 and the adjacent separation chamber 3. The first diaphragm 5 is provided with a first slit 7 (see Fig. 3). The second diaphragm 6 is arranged between the second target material coating chamber 2 and the adjacent separation chamber 3. A second slit 17 is provided on the second diaphragm 6 (see Fig. 4). The first slit 7 and the second slit 17 are the transmission channels of the substrate through the first target material coating chamber 1 and the second target material coating chamber 2. The first blowing device 8 is used to blow air through the first slit 7 to the first target material coating chamber 1 adjacent to the slit 7. The second blowing device 18 is used to blow air through the second slit 17 to the second target material coating chamber 2 adjacent to the slit 8.

In one exemplary embodiment of the present disclosure, the first blowing device 8 blows out the same gas as the gas in the first target material coating chamber 1, and the second blowing device 18 blows out the same gas as the gas in the second target material coating chamber 2. In an optional embodiment, in order to reduce the contamination of gas in the first target material coating chamber 1 and the second target material coating chamber 2, which is produced by the first blowing device 8 and the second blowing device 18. The gas passed through to the first blowing device 8 is the same as the main sputtering gas in the first target material coating chamber 1, and the gas passed through the second blowing device 18 is the same gas as the main sputtering gas in the second target material coating chamber 2. In addition, it should be understood that, for ease of manufacture, the first diaphragm 5 and the second diaphragm 6 may have the same structure.

In one exemplary embodiment of the present disclosure, as shown in fig. 2, the coating apparatus also includes a first pump chamber 13, a second pump chamber 14 and a molecular pump 4. The first pump chamber 13 is arranged in a first target material coating chamber 1, and the first pump chamber 13 is arranged near the first diaphragm 5. The second pump chamber 14 is arranged in the second target material coating chamber 2, and the second pump chamber 14 is arranged near the second diaphragm 6. The first pump chamber 13 and the second pump chamber 14 are respectively provided with a molecular pump 4. The molecular pump 4 in the first pump chamber 13 is used to absorb gas blown back from the first slit 7 by the first blowing device 8. The molecular pump 4 in the second pump chamber 14 is used to absorb the gas blown back from the second slit 17 by the second blowing device 18. By setting the molecular pumps 4, the gas returned by the first blowing device 8 or the gas returned by the second blowing device 18 can all be absorbed, respectively, so as to avoid the mixture of the blown gas and the gas in the target material coating chamber. The gas diffusion between the first target material coating chamber 1 and the second target material coating chamber 2 is further reduced.

It is understood that in order to enable the substrate to move through the target material coating chamber and the separation chamber 3, a slit is also arranged between the first pump chamber 13 and the separation chamber 3, and the second pump chamber 14 and the separation chamber 3 are also provided with a slit. In one embodiment of the present disclosure, on the one side, the gas blown out by the first blowing device 8, and the gas dissipated from the first pump chamber 13 to the first slit 7 are all blown into the first pump chamber 13 and extracted by the molecular pump 4 in the first pump chamber 13; On the other side, the gas blown by the first blowing device 8 will form a relative high pressure shielding area around the first slit 7 to prevent the gas at the side of the first pump chamber 13 from escaping through the first slit 7 to the adjacent separation chamber 3. It should be understood that, for ease of manufacture, the second purge 18 has the same structure, the same position and the same function as the first blowing device 8 respectively.

Further, in one optional embodiment, as shown in fig. 2, a molecular pump 4 is also provided in the separation chamber 3, The molecular pump 4 of the separation chamber 3 is used to absorb a small amount of gas in the separation chamber 3 diffused from the first target material coating chamber 1 and the second target material coating chamber 2 under extreme conditions.

In one exemplary embodiment of the present disclosure, as shown in fig. 2, the first blowing device 8 is located on the side of the first diaphragm 5 facing to the separation chamber 3, and the second blowing device 18 is located on the side of the second diaphragm 6 facing to the separation chamber 3. Optionally, the first blowing device8 is located next to the first slit 7 (shown in fig. 3). The second blowing device 18 is located next to the second slit 17 (shown in fig. 4). Based on this arrangement, the blowing range of the first blowing device 8 completely covers the absorption range of the molecular pump 4 in the first pump chamber 13, and the blowing range of the second blowing device 18 completely covers the absorption range of the molecular pump 4 in the second pump chamber 14. In addition, the first blowing device 8 does not blow the gas in the separation chamber 3 into an area outside of the first pump chamber 13, and the second blowing device 18 does not blow the gas in the separation chamber 3 into an area outside of the second pump chamber 14. It should be understood that the first blowing device 8 may be fixed to the first diaphragm 5 through a fastener or a magnetic member, and the second blowing means 18 may be fixed to the second diaphragm 6 through a fastener or a magnetic member. Thus, the first blowing device 8 and the second blowing device 18 may be disassembled and installed as separate components, respectively. Of course, the fixing mode of the first blowing device 8 and the second blowing device 18 provided by the present invention are not limited to this, and the first blowing device 8 and the second blowing device 18 may also be fixed respectively by an additional support arranged in the separation chamber 3. The specific setting position and height of the support may be set according to experience of the ordinary technical personnel in the art, at the same time ensured that the arrangement of the first blowing device 8 corresponds to the first slit 7, and the second blowing device 18 corresponds to the second slit 17.

In one exemplary embodiment of the present disclosure, the first blowing device 8 of the second blowing device 18 may employ any device with a blowing function, but in order to ensure the isolation effect, the present embodiment provides a first blowing device 8 having the configuration shown in fig. 3 and a second blowing device 18 having the configuration shown in fig. 4. As shown in figure 3, the first blowing device 8 includes: an end plate 10, a pipe 9, a pipeline 15, one or more nozzle 12, and a flow control valve 11. The end plate 10 is fixed at the first slit 7. The pipe 9 is fixed on the end plate 10. And the pipe 9 extends along the length of the first slit 7. The nozzles 12 is arranged on the pipe 9. The pipeline 15 is used to connect the pipe 9 and a gas source 16. The flow control valve 11 is arranged on the pipeline 15, and the switch of the flow control valve 11 can be adjusted to adjust the gas volume to meet the requirements of the coating process. It should be understood that, for ease of manufacture, the first blowing device 8 and the second blowing device 18 may have the same structure, described above only as examples with the first blowing device 8, and the coating apparatus is provided by the present disclosure. Of course, in order to achieve different functions, the first blowing device 8 and the second blowing device 18 may also have different structures.

In an exemplary embodiment of the present disclosure, as shown in fig. 3, the number of the end plates 10 is two and fixed respectively by screws to the both ends of the first slit 7 alone the length direction, respectively. The pipe 9 is fixed on two end plates 10, a gas inlet end of the pipe 9 is connected with a gas outlet end of the flow control valve 11, and a gas inlet end of the flow control valve 11 is connected with the air source 16 through the pipeline 15. In this way, the flow control valve 11 can control the air supply of the pipe 9 to achieve better blowing effect.

As described above, the number of end plates 10 is two, and is fixed respectively on both ends of the first slot 7. However, the invention is not limited to this. The number of the end plates 10 may be one or more. For example, when the number of the end plate 10 is 1, one end of the pipe 9 may be suspended or the end plate 10 may support the pipe 9 from the bottom of the pipe 9. This reduces the number of components used in the first blowing device 8, thereby reducing costs.

In one exemplary embodiment of the present disclosure, the end plate 10 is elastic along the length direction "a" of the slit, in order to adjust the size of the end plate 10 to cover the area of the first slit 7 as necessary, and the end plate 10 of such a configuration may reduce the amount of gas being blown into the corresponding chamber, for example, only a small amount of gas enters the separation chamber 3 from the end of the first slit 7, thus more effectively reducing the gas flowing between the adjacent target material coating chambers. Optionally, the end plate can be stretched through a structure such as a telescopic cylinder.

In one exemplary embodiment of the present disclosure, the pipe 9 is detachably inserted into the end plate 10, so that the pipe 9 and the end plate 10 can be manufactured separately and replaced separately as separate components, thereby reducing the complexity of manufacture and replacement. And when transported or stored, the pipe 9 and the end plate 10 can be separated to reduce the space occupied.

In one exemplary embodiment of the present disclosure, the pipe 9 is arranged around the first slit 9. In an optional embodiment, as shown in fig. 3, the pipe 9 is arranged and closed along the edge of the first slit 7. That is, the pipe 9 has a ring shape along the circumference of the first slit 7, and the placing track of the pipe 9 can overlap the edge track of the first slit 7 to achieve a better blowing effect. Further, a plurality of nozzles 12 provided on the pipe 9 may be arranged along the length direction of the slit 7. Further, a plurality of nozzles are arranged at equal intervals to avoid partial gas dispersion.

In one exemplary embodiment of the present disclosure, an annular pipe 9 is formed by a plurality of segments of pipe splicing. As shown in fig. 3, the annular pipe 9 is arranged around the first slit 7 of the rectangle, in which case the annular pipe 9 may be, for example, composed of four segments corresponding to the four edges of the first slit 7 of the rectangle. In this case, the annular pipe 9 may be composed of four sub-pipes corresponding to the four edges of the first slot 7 of the rectangle. For the pipe 9 with splicing construction, each sub-pipe can be rotated separately to adjust the gas outlet direction of nozzles 12. It can be seen that the pipe 9 with splicing structure can adapt to various working conditions to achieve better blowing effect. It should be understood that the number of the sub-pipe of the annular pipe 9 can be arranged arbitrarily according to the practical application as long as it can be easily manufactured assembled and can achieve a better blowing effect.

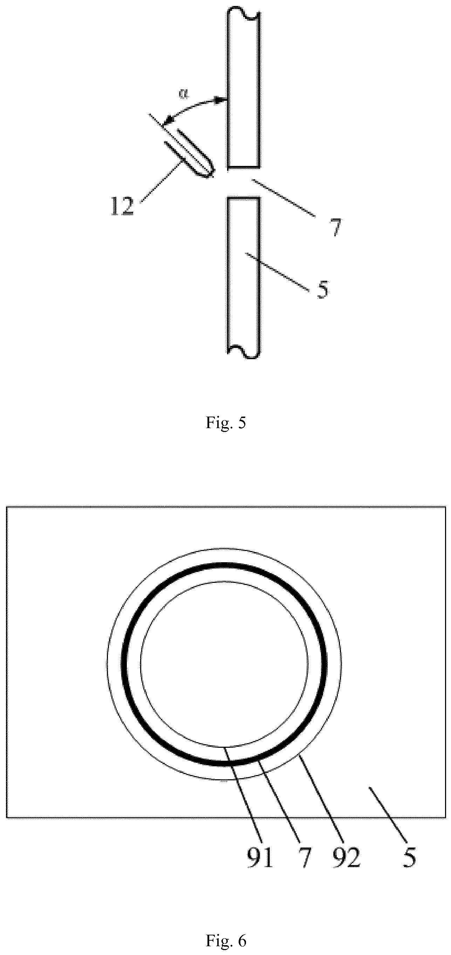

In one exemplary embodiment of the present disclosure, as shown in fig. 5, the nozzles 12 of the first blowing device corresponding to the first diaphragm 5 blow towards the first slit 7. The center axis of the nozzles 12 and the plate surface of the first diaphragm 5 show the first inclination angle α, the first inclination angle α is 30-60 degrees, and the better selection is 45 degrees. Understandably, in order for the gas blown back from the first slit 7 to be absorbed by the molecular pump 4 as soon as possible, the gas outlet of the nozzles 12 is directed to the direction of the molecular pump 4 in the first pump chamber 13. In this way, the nozzles 12 can realize uniform blowing towards the first slit 7 in the vertical and horizontal direction, thus realizing the best blowing effect. Similarly, the nozzles 12 corresponding to the second diaphragm 6 blows towards the second slit 17. The center axis of the nozzles 12 has a second inclination angle with the plate surface of the second diaphragm 6, and the second inclination angle is 30-60 degrees, and the better selection is 45 degrees. It is understood that the gas outlet of the nozzles 12 of the second blowing device corresponding to the second diaphragm 6 is oriented towards the molecular pump 4 in the second pump chamber 14.

In one exemplary embodiment of the present disclosure, as shown in fig. 3, the pipe 9 has a plurality of nozzles12 uniformly arranged along the length direction of the first slit 7. The nozzles 12 can avoid the formation of airflow dead zone and the gas emission in the target material coating chamber. The gas flowing between adjacent target material coating chambers can be effectively reduced and the coating quality can be improved by using this kind of pipe 9 with simple fabrication and low cost.

In addition, in one exemplary embodiment of the present disclosure, the inner surface of the first slit 7 is made into the rough surface by a sandblasting process, which may also play the role of reducing the gas flowing. Ideally, the roughness of the rough surface is Ra > 6.3, where Ra is a unit of measurement of surface roughness, and Ra is the arithmetic average of the absolute deviation of the contour within the sampling length, Using Ra to express roughness grade is an international measurement method of surface roughness.

In one exemplary embodiment of this disclosure, the first slit 7 has a rectangular shape, as shown in fig. 3. The rectangular slit can be suitable for plates coating. But the invention is not limited to this, the first slit 7 may also have any other suitable shape. For example as shown in fig. 6 the first slit 7 may have a circular shape and the pipe 9 is arranged in two circles along the extension direction of the first slit 7 to accommodate a cylindrical target material. In this case, the pipe 9 may be arranged as a two-ring pipe, including the inner ring pipe 91 and the outer ring pipe 92, the inner ring pipe 91 are located within the circular first slit 7 and the outer ring pipe 92 are located outside the circular first slit 7. A number of nozzles can be further arranged on the outer ring pipe to form two-ring shape, which adapt to the situation that the circular slit may cause a large amount of dissipated gas and need a large amount of blowing gas. It should be understood that in fig. 6 a number of nozzles 12 uniformly arranged on the inner ring pipe 91 and the outer ring pipe 92 are omitted in order to clearly show the inner ring pipe 91 and the outer ring pipe 92 of the pipe 9.

In one exemplary embodiment of the present disclosure as described above the gas in the first pump chamber 13, the second pump chamber 14 and the separation chamber 3 are respectively absorbed through the molecular pump 4 arranged within them. In order to ensure the isolation effect, as shown in figure 2, the number of molecular pumps 4 in the separation chamber 3 is set to four, and the number of molecular pumps 4 in the first pump chamber 13 and the second pump chamber 14 is set to two. In one embodiment, the number of molecular pumps 4 in the separation chamber 3 is two, the number of the molecular pumps 4 in the first pump chamber 13 and the second pump chamber 14 is one. It is understandable, of course, that the number of the molecular pump 4 can be adjusted respectively according to the width of the target material coating chamber in order to ensure the isolation effect. In another embodiment, the number of molecular pumps in the separation chamber 3 may be set to six, and the number of molecular pumps 4 within the first pump chamber 13 and the second pump chamber 14 may be set to three. In order to ensure an equilibrium of air pressure between the separation chamber and the slit, the number of molecular pumps in the first pump chamber 13 and the second pump chamber 14 is equal in one optional embodiment, and the sum of the two is equal to the number of molecular pumps in the separation chamber. Through this structure design, the phenomenon of gas flowing between adjacent target material coating chambers can be effectively reduced, and the coating quality can be improved.

Understandably, the above embodiments are only exemplary embodiments used to illustrate the principles of the present disclosure, but the present disclosure is not limited thereto. For ordinary technical personnel in the art, variations and improvements may be made without departing from the spirit and substance of the present disclosure, which are also regarded as the scope of protection of the present disclosure.

## Claims

1. A coating apparatus for coating a substrate surface, comprising:
a plurality of separation chambers (3) and a plurality of target material coating chambers (1), wherein at least one separation chamber (3) is arranged between said two adjacent target material coating chambers (1);
a plurality of diaphragms (5), which divide the internal of said coating apparatus into the plurality of separation chambers (3) and the plurality of target material coating chambers (1), wherein each of said diaphragms (5) is provided with a slit (7), so that said substrate moves between said target material coating chamber (1) and said separation chamber (3) through said slit (7); and
a blowing device (8), which is arranged in one separation chamber (3) and blows gas through said slit (7) to said target material coating chamber (1) adjacent to said slit (7).

2. The coating apparatus according to claim 1, wherein said adjacent two target material coating chambers (1) comprise a first target material coating chamber (1) and a second target material coating chamber (2);
said diaphragms (5) comprise a first diaphragm (5) and a second diaphragm (6);
said slits (7) comprise a first slit (7) and a second slit (17), said blowing devices (8) comprise a first blowing device (8) and a second blowing device (18);
wherein said first diaphragm (5) is arranged between said first target material coating chamber (1) and said adjacent separation chamber (3), said first slit (7) is arranged on said first diaphragm (5), said second diaphragm (6) is arranged between said second target material coating chamber (2) and said adjacent separation chamber, and said second slit (17) is arranged on said second diaphragm (6), said first blowing device (8) is used for blowing gas to said first target material coating chamber (1) through said first slit (7), and said second blowing device (18) is used for blowing gas to said second target material coating chamber (2) through said second slit (17).

3. The coating apparatus according to claim 1, wherein the coating apparatus further comprises:
a first pump chamber (13), which is arranged in said first target material coating chamber (1) and is near said first diaphragm (5), and
a second pump chamber (14), which is arranged in said second target material coating chamber (2) is near said second diaphragm (6),
wherein said first pump chamber (13) and said second pump chamber (14) are provided with a molecular pump (4) respectively, said molecular pump (4) in said first pump chamber (13) is used to absorb gas blown back from said first slit (7) by said first blowing device (8), said molecular pump (4) in said second pump chamber (14) is used to absorb gas blown back from said second slit (17) by said second blowing device (18).

4. The coating apparatus according to any one of claims 1 to 3, wherein a molecular pump (4) is arranged in said separation chamber (3) for absorbing gas in said separation chamber (3).

5. The coating apparatus according to any one of claims 2 to 4, wherein said first blowing device (8) is arranged on one side of said first diaphragm (5) facing to said separation chamber (3), and said second blowing device (18) is arranged on the other side of said second diaphragm (6) facing to said separation chamber (3).

6. The coating apparatus according to any one of claims 2 to 5, wherein each of said first blowing device (8) and said second blowing device (18) comprises:
an end plate (10), said end plate (10) is fixed at said slit (7);
a pipe (9) is fixed on said end plate (10), and said pipe (9) extends along said direction of the length of said corresponding slit (7);
one or more nozzles (12) are arranged in said pipe (9);
a pipeline (15) is used to connect said pipe (9) and said gas source (16); and
a flow control valve (11) is arranged on said pipe (9);
wherein said slit (7) corresponding to said first blowing device (8) is said first slit (7), and said slit (17) corresponding to said second blowing device (18) is said second slit (17).

7. The coating apparatus according to claim 6, wherein said pipe (9) is arranged around said edge of said slit (7).

8. The coating apparatus according to any one of claims 7 to 8, wherein said slit (7) is circular, and said pipes (9) comprises:
an inner ring pipe (91), which is located inside said circular slit (7), and
an outer ring pipe (92), which is located outside said circular slit (7).

9. The coating apparatus according to any one of claims 6 to 8, wherein said nozzles (12) of said first blowing device (8) blow towards the first slit (7), the center axis of said nozzles (12) and the plate surface of said first diaphragm (5) shows a first inclination angle α, said first inclination angle α is 30-60 degrees, and an outlet of said nozzles (12) of said first blowing device (8) is oriented towards said molecular pump (4) in said first pump chamber (4) adjacent to said nozzles (12).

10. The coating apparatus according to any one of claims 6 to 9, wherein said nozzles (12) of said second blowing device (18) blow towards the second slit (17), the center axis of said nozzles (12) and the plate surface of said second diaphragm (6) shows a second inclination angle α, said second inclination angle α is 30-60 degrees, and an outlet of said nozzles (12) of said second blowing device (18) is oriented towards said molecular pump (4) in said second pump chamber (14) adjacent to said nozzle (12).

11. The coating apparatus according to any one of claims 6 to 10, wherein said nozzles (12) are arranged evenly along the extension direction of said pipe (9).

12. The coating apparatus according to any one of claims 6 to 11, wherein said end plate (10) is located at least one end of said slit (7), and said end plate (10) is elastic along the length direction of said slit (7) so that said end plate (10) covers an area of said slit (7) adjustable.

13. The coating apparatus according to any one of claims 6 to 12, wherein the pipe (9) is detachable with said end plate (10).

14. The coating apparatus according to any one of claims 2 to 13, wherein an inner surface of said first slit (7) and an inner surface of said second slit (17) are rough surfaces, and the roughness of each inner surfaces is Ra > 6.3.

15. The coating apparatus according to any one of claims 4 to 14, wherein the number of said molecular pumps (4) in said first pump chamber (13) is equal to the number of said molecular pumps (4) in the second pump chamber (14), and a sum of the number of said molecular pumps (4) in said first pump chamber (13) and the number of said molecular pumps (4) in said second pump chamber (14) is a first value, a sum of the number of said molecular pumps (4) in said separation chamber (3) is a second value, and said first value is equal to said second value.
